# FASCICULE DE BREVET EUROPEEN

(11) **EP 2 224 476 B1**
(45) Date de publication et mention de la délivrance du brevet: **22.01.2014**
(21) Numéro de dépôt: 10154264.5
(22) Date de dépôt: 22.02.2010
(51) Int. Cl.: H01L 21/762

(54) **Procédé d'élaboration d'un substrat hybride par recristallisation partielle d'une couche mixte**
Herstellungsverfahren eines Hybridsubstrats durch teilweise Rekristallisierung einer Mischschicht
Method for manufacturing a hybrid substrate by partial re-crystallisation of a mixed layer

(30) Priorité: 27.02.2009 FR 0951247
(43) Date de publication de la demande: 01.09.2010
(73) Titulaire: Commissariat à l'Énergie Atomique et aux Énergies Alternatives, 75015 Paris (FR)
(72) Inventeur: Fournel, Franck, 38190, VILLARD-BONNOT (FR); Signamarcheix, Thomas, 38660, LA TERRASSE (FR); Clavelier, Laurent, 38120, SAINT EGREVE (FR); Deguet, Chrystel, 38330, SAINT ISMIER (FR)
(74) Mandataire: Colombo, Michel

(56) Documents cités:
- FR-A- 2 917 235
- US-A1- 2005 116 290
- US-A1- 2006 024 931
- US-A1- 2007 013 001

## Description

L'invention concerne un procédé de formation d'un substrat hybride, c'est-à-dire une structure micro-technologique comportant une couche mixte formée de familles de zones différentes, en ce qui concerne leurs matériaux constitutifs ou au moins en ce qui concerne leurs orientations cristallines. Un tel substrat est parfois aussi appelé « substrat mixte », en raison de la mixité des zones au sein d'une même couche.

Il est à noter que l'épaisseur d'une couche mixte est typiquement comprise entre 1 nm et 50µm.

Dans le domaine de la micro-technologie, lorsqu'il s'agit de produire des composants électroniques, des composants optiques ou optoélectroniques, voire des composants micro-mécaniques (des micro-accélérateurs, par exemple), on utilise souvent des substrats en silicium, mais il faut bien comprendre que d'autres matériaux sont également utilisables, souvent d'autres matériaux semi-conducteurs, formés d'éléments de la colonne IV du tableau périodique des éléments (germanium, notamment, ainsi que ses alliages avec du silicium), voire des colonnes III-V (notamment GaAs ou InP), ou même II-VI de ce tableau, voire LiNb03, SiC, le diamant, etc.

L'utilisation, et tout particulièrement la réalisation, de tels substrats hybrides, que la couche mixte soit enterrée ou en surface, présente un intérêt pour diverses applications, notamment dans les dispositifs de type MOS.

Dans ce dernier cas, compte tenu des limitations que rencontrent les dispositifs MOSFET en termes de performances, le changement de l'orientation cristalline de la surface du substrat utilisé (majoritairement Si), tout comme le changement de la direction du canal de conduction des transistors, apparaît comme une solution simple et performante. En effet, de nombreuses études ont démontré l'impact de l'orientation de la surface libre et de la direction du canal de conduction sur les mobilités respectives des trous et d'électrons. Ainsi, une amélioration de la mobilité des porteurs (trous) peut elle être assurée via l'utilisation d'une surface libre d'orientation <110> en comparaison avec une surface libre usuelle de type <100>, comme l'ont récemment rappelé Yang et al. (voir la référence 1 ci-dessous). Toutefois, les technologies CMOS reposent sur l'utilisation simultanée de transistors de type n-MOS (conduction par les électrons) et de type p-MOS (conduction par les trous). En outre, un changement de l'orientation de la surface a des effets antagonistes sur les électrons et sur les trous, nécessitant donc deux orientations de surface libre, différentes pour ces deux types de porteurs. Ainsi il convient de pouvoir produire et faire cohabiter deux types d'orientations sur un même substrat.

On comprend que, selon les applications visées, la couche hybride peut, ou non, longer une couche électriquement isolante.

On connaît déjà des techniques de réalisation de structures hybrides.

On peut se référer, par exemple, au document WO - 2004/059711 ou à son équivalent US - 2006/0166461, qui proposent la formation d'une structure mixte ou hybride, par collage moléculaire de deux substrats dont l'un comporte en surface deux types de zones différant par leurs matériaux constitutifs ; ces deux types de zones sont, dans ce document, obtenus par des techniques de lithographie, gravure, oxydation thermique en surface et polissage pour ne laisser subsister l'oxyde thermique que dans des zones gravées. Un perfectionnement de cette technique est proposé dans le document EP - 1 923 912, ou son équivalent US - 2008/0079123, qui enseigne la formation d'une couche sacrificielle garantissant la planéité des surfaces finalement mises à nu.

Par ailleurs, le document précité de Yang et al (référence 1), propose, au lieu de la mise en oeuvre d'une oxydation thermique pour remplir les zones gravées, de creuser par gravure des cavités dans un substrat SOI (donc avec une couche semi-conductrice au dessus d'une couche électriquement isolante enterrée), jusqu'au travers de la couche isolante, et de provoquer le remplissage de ces cavités par épitaxie à partir du fond de ces zones gravées, lequel fond est constitué par un matériau (sous cette couche isolante) choisi en sorte d'avoir une cristallographie différente de celle des zones non gravées. Cette technique est commentée plus en détail dans la référence 2.

Yang et al. (voir la référence 3) ont démontré, au travers d'une simulation, l'importance de disposer d'un isolant électrique enterré continu sous les zones d'orientations différentes, et ont proposé une modification de leur méthode d'élaboration (telle que définie dans la référence 2) visant à minimiser les interruptions de la couche électriquement isolante enterrée ; cette modification consiste à prévoir que la gravure au travers de la couche électriquement isolante enterrée se fait sur une section inférieure à celle de la cavité creusée dans la couche située au-dessus de cette couche isolante.

On comprend toutefois que le dépôt par épitaxie est une technique soumise à des contraintes opératoires assez strictes, ce qui engendre parfois un coût significatif

Une autre technique d'élaboration est décrite par Yin et al. (voir la référence 4) ; cette technique est fondée sur l'utilisation d'une structure dite « DSB » (Direct Silicon Bonding), c'est-à-dire obtenue par collage direct de deux substrats de Silicium d'orientations cristallines différentes : par lithographie et implantation d'ions, on amorphise sélectivement des zones de l'un des substrats, sur toute son épaisseur jusqu'à l'interface entre les deux substrats, et on provoque la recristallisation des zones amorphisées suivant la cristallographie de l'autre substrat ;il est en fait mentionné que, à moins de former, avant recristallisation, des tranchées entre les zones amorphisées et les zones non amorphisées, on observe deux phénomènes concurrents de recristallisation, à partir du substrat sous-jacent (selon une première orientation cristallographique) et à partir des zones adjacentes (selon une autre orientation cristallographique).

Ce principe d'une recristallisation en phase solide semble présenter des avantages sensibles, notamment en termes de coût, par rapport à la technique de l'épitaxie, mais on comprend donc que la mise en oeuvre pour la fabrication d'une couche mixte ne permet pas un contrôle précis de la microstructure des zones initialement amorphes auprès des autres zones ; la géométrie finale des zones initialement amorphes de la couche mixte dépend en effet, à moins de prévoir des tranchées entre les zones adjacentes, de la compétition de la recristallisation tangentielle à partir des « autres » zones et de la recristallisation verticale à partir du substrat sous-jacent, ce qui peut aboutir à des trapézoïdales involontaires. Plus généralement, il peut être important de pouvoir garantir que la couche mixte a sensiblement la même géométrie et/ou la même structure auprès des arêtes inférieures et supérieures de ces autres zones.

On peut noter que les technologies mentionnées ci-dessus concernent l'élaboration de substrats hybrides dont la couche mixte est en surface, mais on comprend qu'il peut également être utile de pouvoir élaborer des substrats hybrides dont la couche mixte est enterrée, sous une autre couche qui est en pratique cristalline.

De l'état de la technique est également connu de :
- US2007/013001 A1,
- FR2917235A,
- US2006/024931A1,
- US2005/116290A1.

L'invention a pour objet un procédé permettant d'élaborer, de manière simple et fiable, un substrat hybride comportant un substrat sous-jacent et une couche mixte formée de familles de zones adjacentes différentes telles que les zones de chaque famille sont constituées d'un matériau prédéterminé en ayant une cristallographie spécifique (du point de vue orientation cristallographique et/ou du point de vue paramètre de maille, une forme amorphe étant ici assimilée à une forme cristallographique), suivant une géométrie bien contrôlée. Le nombre de familles de zones est souvent de deux, mais on comprend qu'il peut être utile, dans certains cas, de pouvoir obtenir qu'une telle couche comporte des zones ayant, de manière prédéfinie, l'une de trois (ou plus) orientations différentes

L'invention propose ainsi un procédé d'élaboration d'un substrat hybride conforme à la revendication 1.

De manière avantageuse, les portions superficielles sont à faces parallèles, au sein de la couche monocristalline.

De manière avantageuse, avant de provoquer la fracture, avantageusement le long d'une zone préalablement fragilisée, on élabore dans le premier substrat des marques de repérage adaptées à être disposées de part et d'autre de la couche de fracture (donc de part et d'autre de cette zone fragilisée avantageuse au moment de cette fracture), selon une configuration relative donnée par rapport à la couche de fracture, et on colle la seconde portion superficielle au substrat provisoire après avoir disposé cette seconde portion en sorte que les marques de repérage soient dans ladite configuration relative donnée par rapport à ladite couche mixte. En pratique cette configuration relative donnée correspond à une disposition de ces marques en regard perpendiculairement à cette couche de fracture (et donc à cette couche mixte). Cela contribue à garantir que les deux portions superficielles sont bien dans la même orientation relative avant fracture et après collage. Ces marques de repérage peuvent être de simples repères visuels ou des creux, des gorges ou autres modifications locales de géométrie.

De manière également avantageuse, après le collage de la seconde portion superficielle et le traitement thermique , on enlève au moins en partie l'une des portions superficielles (voire les deux) vis-à-vis de la couche mixte, ce qui permet que la couche mixte soit à une profondeur bien définie, éventuellement nulle, vis-à-vis d'une surface mise à nu par cet enlèvement. Cet enlèvement peut se faire par séparation entre la portion superficielle et les zones au moins en partie recristallisées de la couche mixte, ou amincissement mécanique et/ou chimique).

On peut noter qu'ainsi l'invention enseigne de provoquer la recristallisation de zones amorphes à partir, non seulement d'un substrat sous-jacent (la portion du substrat initial sur laquelle on a formé la couche mixte), mais aussi d'une couche de référence (l'autre portion du substrat initial) rapportée par collage moléculaire (de manière éventuellement uniquement temporaire). Compte-tenu de ce que ce substrat sous-jacent et cette couche de référence sont issus d'un même substrat de départ, et que, au moment du collage de la seconde zone superficielle, on s'assure que ce sont les faces en regard issue de la séparation qui sont assemblées de part et d'autre de la couche mixte avec la même orientation qu'avant la séparation (grâce à l'alignement des marques de repérage réalisées avant séparation, lorsqu'elles existent), l'invention permet de minimiser les risques qu'il y a ait des désalignements cristallographiques (aussi bien dans le plan que hors du plan d'assemblage) à la rencontre des fronts de recristallisation sélective des zones amorphes, depuis le substrat sous-jacent et depuis la couche de référence sus-jacente.

De manière avantageuse, l'obtention des deux portions superficielles est réalisée selon la technique connue sous le nom de « Smart Cut ^{™}», par fragilisation du substrat de départ, à une profondeur donnée, au sein de la couche monocristalline, par implantation d'ions tels que des ions hydrogène, ou des ions d'hélium, par exemple, puis par éventuel collage sur un substrat porteur (si cela est utile) puis par application d'une énergie thermique et/ou mécanique pour provoquer la séparation au niveau de la zone implantée. Cette séparation peut, ou non, être suivie par une étape de polissage des surfaces ainsi mises à nu.

En fait l'invention permet de s'abstenir d'avoir à recristalliser les zones amorphes sur la totalité de leur épaisseur ; en effet, le fait qu'il y ait deux fronts de recristallisation permet de garantir que ces zones sont recristallisées de la même manière auprès des deux portions superficielles, des deux côtés de la couche mixte, même s'il subsiste une fraction médiane des zones amorphes qui n'est pas recristallisée. La recristallisation peut être poursuivie ensuite avec un autre recuit avant ou après l'enlèvement de tout ou partie d'une des portions superficielles.

Il est intéressant de noter que, puisque l'on enlève par séparation la couche de référence formant germe vis-à-vis du substrat hybride, cette couche de référence peut être utilisée pour un nouveau cycle de séparation et de formation de substrat hybride.

On comprend que, lorsque l'on souhaite que la couche formant germe ne soit fixée que temporairement avant d'être enlevée par séparation, il est avantageux que la séparation de cette couche vis-à-vis de la couche mixte puisse se faire, après recristallisation, par décollement au niveau de l'interface de collage ou par fracture auprès de celle-ci , c'est pourquoi, de manière avantageuse, soit la tenue mécanique de l'interface est volontairement dégradée, soit la tenue mécanique de la couche formant germe est volontairement dégradée auprès de cette interface de collage. Toutefois, contrairement à ce que l'on pouvait craindre, il est apparu qu'une telle dégradation, ou fragilisation, n'empêche pas la couche de référence d'assurer efficacement son rôle de germe de recristallisation au travers de l'interface.

Une telle dégradation de l'interface de collage, visant à réduire l'énergie de collage malgré la consolidation qui intervient normalement du fait d'un traitement thermique tel que le traitement de recristallisation, peut notamment être assurée par un traitement de rugosification de l'une et/ou l'autre des faces destinées à être collées par collage moléculaire ; pour des raisons pratiques il est avantageux de rugosifier la surface libre d'au moins la couche de référence.

La rugosité ainsi obtenue est avantageusement comprise entre 0.1 nm et 1 nm RMS, par exemple de l'ordre de 0.2nm RMS (par mesure AFM, c'est-à-dire par mesure par force atomique, par exemple sur une surface de 5 microns x 5 microns). Cette rugosification est avantageusement obtenue par une gravure, par exemple, au moins dans le cas d'une couche de silicium monocristallin, dans une solution d'eau, d'ammoniaque et d'eau oxygénée (H2O, NH4+/OH- et H2O2 dans des proportions 1-1-5 à 70°C pendant 15mm (il est à la portée de l'homme de métier de choisir une solution appropriée à chaque matériau à graver)

Au lieu de modifier la rugosité des couches destinées à être collées, on peut prévoir une couche sacrificielle entre ces deux surfaces, sous réserve que cette couche conserve l'information cristalline à transmettre et permette ainsi que la couche formant germe assure son rôle lors de la recristallisation. A titre d'exemple, cette couche sacrificielle peut être un alliage qui est épitaxié sur la couche formant germe, par exemple du SiₓGe₍₁₋ₓ₎ ; dans le cas où l'on souhaite recristalliser des portions amorphes de silicium par un germe monocristallin de silicium, cette couche devra être d'épaisseur inférieure à l'épaisseur critique (épaisseur jusqu'à laquelle du SiGe croît avec le paramètre de maille du silicium sous-jacent, conservant ainsi l'information cristalline du silicium ; pour du Si_{0,8}Ge_{0,2} sur Si, on se limitera typiquement à une épaisseur de 5nm). Après collage et recuit de recristallisation, pour obtenir la séparation, il suffit alors d'éliminer une grande partie du substrat germe, par exemple par rectification mécanique ou par fracture au niveau d'une zone fragile enterrée réalisée préalablement dans le substrat germe, puis de mettre en oeuvre une ou plusieurs solutions d'attaque sélective de tout type connu approprié pour éliminer la partie du germe résiduelle, s'il en existe, puis la couche sacrificielle de SiGe (une solution connue par exemple pour graver sélectivement le SiGe par rapport au silicium est HF/HN03).

Pour faciliter le décollement, on pourra prévoir également de limiter le budget thermique de recristallisation (qui tend en même temps à renforcer l'interface de collage). On peut par exemple prévoir de recristalliser seulement une faible partie des zones amorphes, en pratique une partie de l'épaisseur de celles-ci, à partir de l'interface de collage, pour limiter la durée d'application du traitement de recristallisation, puis de procéder au décollement (tant que l'interface de collage a une tenue modérée) puis de poursuivre et compléter la recristallisation des zones amorphes par l'application d'un budget thermique complémentaire. Cela permet de limiter le budget thermique pré-décollement (et donc de garantir que la structure sera décollable) tout en transférant l'information cristalline « de l'autre coté » au travers de l'interface de collage. Il est rappelé que la notion de budget thermique englobe à la fois la température d'un traitement et sa durée.

Une telle recristallisation en deux étapes de traitement, avec un premier traitement qui n'est adapté à provoquer la recristallisation que d'une partie (en pratique, une partie de l'épaisseur) des zones amorphes et, après séparation, l'application d'un second traitement thermique (voire de plusieurs traitements thermiques) adapté(s) à poursuivre et compléter la recristallisation de ces zones amorphes, a aussi, indépendamment de l'endroit où se fait la séparation, un avantage énergétique puisque le traitement thermique complémentaire n'a pas besoin d'être appliqué à la couche formant germe.

On comprend aisément que, bien que cela soit avantageux, il n'est pas nécessaire que la recristallisation soit obtenue, partout dans les zones à recristalliser, sur une même partie de l'épaisseur de celles-ci ; il suffit que la partie de ces zones qui est recristallisée soit suffisamment importante pour servir de germe au reste de la zone, lors du traitement thermique postérieur à la séparation.

Une manière de dégrader la tenue mécanique de la couche de référence consiste à rendre poreuse au moins une partie de cette couche, à proximité de l'interface. En fait, il n'est pas nécessaire que cette zone poreuse soit exactement adjacente à cette interface, même si cela est avantageux pour permettre une fracture très proche de l'interface. On comprend en effet que, lorsque la séparation se fait à distance de l'interface, des traitements classiques de polissage, mécaniques et/ou chimiques et/ou thermique, permettent d'éliminer le résidu de la couche de référence restant collé après fracture dans la couche poreuse.

En variante la fragilisation de la couche de référence peut être réalisée, à une profondeur donnée, par implantation d'ions, conformément à la technique connue sous le nom de « Smart Cut ^{™} ». Une telle implantation est avantageusement réalisée avant collage, de manière à ce que la fragilisation résultant de l'implantation puisse se développer durant le traitement thermique de recristallisation. La séparation a ensuite lieu au sein de cette couche fragile.

Cette couche de référence a de préférence une épaisseur comprise entre quelques nanomètres et plusieurs centaines de microns.

Le premier matériau constitutif du substrat initial (donc celui du substrat sous-jacent et de cette couche de référence) est avantageusement identique à celui des zones amorphes (troisième matériau), ce qui a pour effet que les zones amorphes se recristallisent selon un paramètre de maille naturelle pour ce matériau. Toutefois, on peut choisir pour ce substrat initial un matériau différent de celui des zones amorphes, lorsque l'on souhaite par exemple recristalliser ces zones amorphes en un état contraint ; à titre d'exemple, l'utilisation de Si_{0.8}Ge_{0.2} relaxé pour la couche de référence contribue à recristalliser des zones amorphes en silicium contraintes en tension.

Le second matériau constitutif des premières zones peut être avantageusement un matériau amorphe comme un oxyde, un nitrure, de l'alumine, du carbone ou un autre matériau à haute constante diélectrique (on parle parfois de matériau « high K ») ; on peut noter à ce propos que les oxydes et nitrures ont souvent des températures de recristallisation (si elles existent) et/ou de changement de phases cristallines très élevées, de sorte qu'un traitement thermique destiné à recristalliser les secondes zones peut être insuffisant en soi, au moins dans certains cas, pour provoquer la recristallisation de ces zones oxydes ou nitrures sous forme amorphe. En variante, le second matériau constitutif des premières zones peut être un matériau cristallin (monocristallin ou polycristallin) comme le silicium ou un quelconque autre matériau semi-conducteur, tel que le germanium ou l'un de ses alliages avec le silicium, d'autres alliages de silicium tels que du SiC, ou des alliages entre des éléments des colonnes III et V du tableau périodique des éléments (par exemple GaAs), voire des colonnes Il et VI, ou encore le diamant, ou le quartz, ou LiTa03, LiNb03, etc. Bien évidement il est recommandé de faire attention dans ce cas que des phénomènes de recristallisation latérale ne perturbent pas la recristallisation verticale. Cela peut se faire naturellement si les paramètres de mailles sont suffisamment différents, sinon il est recommandé d'empêcher le contact cristallin en effectuant par exemple des tranchées remplies ou non d'un matériaux amorphe Toutefois, cette recristallisation latérale peut ne pas être un problème si son extension est prévue au départ (par exemple si les zones amorphes sont bien plus larges qu'épaisses, la recristallisation verticale sera terminée avant que la recristallisation latérale n'ait beaucoup progressé. Le raccord entre les deux fronts de recristallisation peut ensuite être enlevé ou non si besoin).

Le troisième matériau constitutif des secondes zones peut être choisi parmi le silicium ou un quelconque autre matériau semi-conducteur, tel que le germanium ou l'un de ses alliages avec le silicium, d'autres alliages de silicium tels que du SiC, ou des alliages entre des éléments des colonnes III et V du tableau périodique des éléments (par exemple GaAs), voire des colonnes II et VI, ou encore le diamant, ou le quartz, ou LiTa03, LiNb03, etc.

La couche mixte peut ainsi être, notamment, réalisée en un seul matériau ayant, selon les zones, l'une ou l'autre de deux (ou plusieurs) orientations cristallographiques prédéfinies. Il s'agit avantageusement d'une couche mixte en silicium, qui est par exemple, selon les zones, orientée suivant <100> ou <110>. Bien évidement il sera recommandé de faire attention dans ce cas que des phénomènes de recristallisation latérale ne perturbent pas la recristallisation verticale. Il pourra être utile d'empêcher le contact cristallin en effectuant par exemple des tranchées remplies ou non d'un matériau amorphe, à moins de prendre en compte cette recristallisation latérale et que cette dernière ne perturbe pas l'application finale de ces substrats

Lorsque la couche mixte est réalisée en un même matériau dans les diverses zones, la formation des secondes zones, amorphes, peut être obtenue en amorphisant des zones au sein d'une couche initialement monocristalline ayant celle des orientations cristallographiques qui n'est pas celle de la couche de référence (à savoir celle qu'auront les premières zones, à la fin de l'élaboration de la couche mixte).

On comprend toutefois que la formation des secondes zones, amorphes, peut aussi se faire par creusement de cavités dans une couche monocristalline (ayant la cristallographie des futures premières zones) puis remplissage de celles-ci par un nouveau matériau, ce qui a l'intérêt notamment de permettre d'obtenir des couches mixtes dont les zones ont non seulement des orientations cristallines différentes, mais aussi des matériaux constitutifs différents. Le fait de former les zones amorphes par dépôt peut avoir, même lorsqu'elles sont en réalisées dans le même matériau du reste de la couche mixte, pour avantage de conduire à une moindre recristallisation des zones amorphes à partir des zones adjacentes, dans la mesure où la formation des zones amorphes par dépôt induit une bien moins bonne compatibilité cristallographique avec ces zones adjacentes que lorsque l'on procède par amorphisation.

Il est à noter que le dépôt du matériau amorphe peut être réalisé dans un four, sur plusieurs substrats (parfois appelées plaquettes lorsqu'il s'agit d'un disque de quelques dizaines de centimètre de diamètre, par exemple 30cm). Il s'agit donc d'un traitement collectif et bien connu, ce qui conduit à une production fiable et rapide pour un coût modéré, ce qui peut constituer un avantage substantiel par rapport à la technique de l'épitaxie.

Les zones de la couche mixte ont avantageusement, que les secondes zones soient réalisées par amorphisation ou par dépôt de matériau amorphe, une épaisseur égale à celle de cette couche, de sorte que la surface libre du premier substrat est elle-même mixte. En variante, les premières zones de la couche mixte ne s'étendent, à partir de la couche continue électriquement isolant, que sur une partie de l'épaisseur de cette couche mixte, le matériau amorphe étant situé non seulement de manière adjacente à ces premières zones, mais aussi au-dessus de celles-ci ; puisque le matériau amorphe s'étend ainsi au-dessus des premières zones et des portions correspondantes des secondes zones, il s'étend de manière continue le long de toute la surface libre du premier substrat ; une telle configuration correspond à un cas où le premier substrat est formé à partir d'une première couche formée du matériau des premières zones, où on creuse des cavités sur toute l'épaisseur de cette première couche et on dépose un matériau amorphe dans ces cavités pour former les secondes zones et sur une épaisseur donnée au-dessus de l'ensemble des premières et secondes zones.

Comme indiqué ci-dessus, le second matériau (constitutif des premières zones de la couche mixte) peut lui-même être amorphe, notamment dans le cas de matériaux « high K » ; le caractère sélectif de la recristallisation des secondes zones, amorphes, peut alors provenir du choix d'une température et d'une durée de recristallisation insuffisants pour provoquer une recristallisation significative de ce second matériau, et/ou de la présence d'une couche formant barrière, formée lors de l'élaboration des zones de la couche mixte, en sorte de maintenir ce matériau amorphe à distance de tout germe pouvant déterminer la recristallisation.

De manière avantageuse, le collage moléculaire est réalisé de manière hydrophobe, de manière à éviter la formation d'un oxyde à l'interface entre les surfaces collées (les conditions d'un tel collage hydrophobe sont bien connues de l'homme de métier. Toutefois, un collage hydrophile, voire hydrophile/hydrophobe est possible.

De manière avantageuse, le traitement thermique de recristallisation est effectué à une température comprise entre 200°C, et 1300°C, de préférence entre 350°C et 800°C, selon les matériaux mis en oeuvre : la durée du traitement est typiquement comprise, selon ces matériaux, entre quelques fractions de secondes et quelques heures (notamment dans le cas du silicium amorphe).

L'enlèvement de la couche de référence formant germe, par séparation vis-à-vis de la couche mixte au moins en partie recristallisée, peut être effectuée par l'insertion mécanique d'un outil (par exemple une lame), ou d'un fluide (notamment, gaz ou eau), ou par des ondes acoustiques, au moins au sein de la zone fragile constituée par (ou dans) la couche formant germe (lorsqu'on l'a rendue poreuse, au moins en partie, ou qu'on y a implanté des ions) ou par l'interface de collage (lorsque son énergie de collage est faible).

Cet enlèvement peut également être obtenu par un amincissement par polissage mécanique et/ou chimique.

Après l'éventuelle séparation entre la couche mixte en partie recristallisée et la couche formant germe, on applique avantageusement un recuit thermique à cette couche mixte afin d'en éliminer les éventuels défauts cristallins encore présents, par exemple à la rencontre des fronts de recristallisation (ce recuit est avantageusement réalisé à une température supérieure à la température à laquelle la recristallisation a été effectuée).

Des étapes de finition peuvent être utiles pour la structure ainsi obtenue, afin d'obtenir notamment un bon état de surface en termes de rugosité, par exemple. Il peut ainsi s'agir d'étapes telles qu'un polissage mécano-chimique, des recuits sous atmosphère réductrice, sous vide...

Le substrat de départ peut être homogène, auquel cas les portions superficielles ont les mêmes propriétés (composition et structure) que le reste du substrat. Toutefois, ce substrat de départ peut être formé d'un support auquel on a fixé une couche monocristalline. Après séparation en deux portions superficielles, l'une d'entre elles peut être fixée, par collage moléculaire, à un support ; c'est ainsi que, par exemple, une plaquette homogène de silicium peut être séparée, en plusieurs cycles, en un film mince (typiquement de moins de 1 micron d'épaisseur) qui est fixé sur un support pour former le substrat sur lequel on forme la couche mixte, tandis que le reste de la plaquette sert de couche de référence, avant d'être détaché et d'être à nouveau séparé en deux portions.

Des objets, caractéristiques et avantages de l'invention ressortent de la description qui suit, donnée à titre illustratif non limitatif, en regard des dessins annexés sur lesquels :
- la figure 1 est une vue en coupe d'un premier substrat au moins en partie monocristallin destiné à participer à l'élaboration d'un substrat hybride selon l'invention après séparation en deux parties,
- la figure 2 est une vue en coupe, après une première étape de préparation d'un substrat provisoire comportant une première partie du premier substrat,
- la figure 3 en est une vue en coupe après la formation d'une couche mixte, selon un exemple de géométrie,
- la figure 4 est une vue en coupe d'un assemblage temporaire de ce substrat provisoire avec l'autre partie du premier substrat,
- la figure 5 est une vue en coupe de cet assemblage après une étape de recristallisation,
- la figure 6 est une vue de cet assemblage après une étape avantageuse de séparation des deux parties du premier substrat,
- la figure 7 est une vue en coupe d'un premier exemple de substrat provisoire à un stade intermédiaire de sa première étape de préparation,
- la figure 8 est une vue en coupe d'un second exemple de substrat provisoire à un stade intermédiaire de sa première étape de préparation,
- la figure 9 est une vue en coupe de ce second exemple de substrat provisoire à un stade ultérieur de sa première étape de préparation,
- la figure 10 est une vue de ce second exemple de substrat provisoire après la formation de la couche mixte et l'assemblage à l'autre partie du premier substrat, et
- la figure 11 est une vue en coupe de l'assemblage de la figure 10 après recristallisation et séparation.

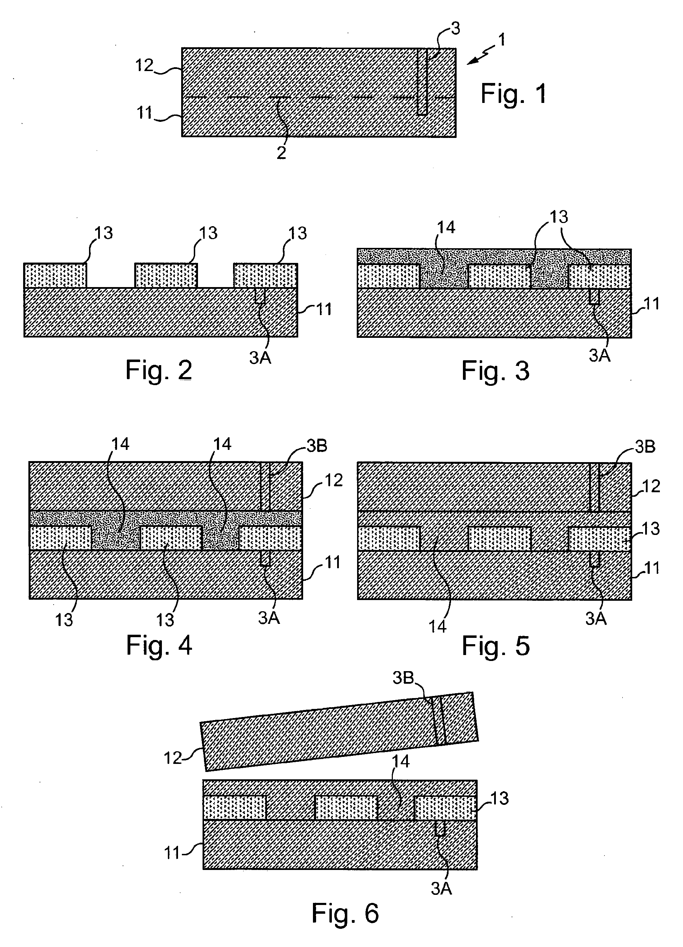

Les figures 1 à 6 illustrent, de manière générale, des étapes d'un exemple de mise en oeuvre du procédé de l'invention.

La figure 1 représente un premier substrat 1 dont au moins une couche (ici la totalité) est monocristalline, en un premier matériau. Ce substrat est par exemple, de manière connue, une plaquette en forme de disque.

Ce premier substrat 1 a préalablement subi un traitement de fragilisation d'une couche 2 schématisée par une ligne en pointillés au sein de la couche monocristalline. Cette fragilisation peut avoir été obtenue par un traitement d'implantation ionique, par exemple par implantation d'ions gazeux tels que de l'hydrogène et/ou de l'hélium. En variante cette fragilisation peut se faire en rendant poreuse une couche du substrat 1.

Des marques de repérages 3 sont créées dans le substrat 1, avant ou après la fragilisation de la couche 2 ; ces marques de repérage sont disposées de part et d'autre de cette couche, selon une configuration relative donnée par rapport à cette couche, de sorte à pouvoir aligner précisément les faces des deux parties cristallines qui vont être générées par fracture à l'étape suivante.

A cet effet, on pourra par exemple réaliser par gravure au moins deux encoches d'alignement, avantageusement en bordure de plaquette et sensiblement opposées diamétralement. Ainsi que cela est représenté à la figure 1, ces encoches ont une profondeur suffisante pour traverser la couche fragile : elles seront ainsi face à face dans les portions du substrat qui sont situées de part et d'autre de cette couche 2 et qui vont être détachées. D'autres marques de repérage peuvent être utilisées : par exemple des rainures réalisées sur la tranche du substrat 1 et s'étendant de part et d'autre de la couche fragile.

Ce premier substrat est séparé en deux parties 11 et 12 par fracture le long de la couche fragilisée 2, ce qui met à nu des faces de deux portions superficielles de cette couche (dans l'exemple ici considéré, puisque le premier substrat est homogène, ces portions superficielles s'étendent à tout ce premier substrat) ; puisque ces portions superficielles proviennent de la fracture d'une même zone monocristalline, ces deux portions ont une même structure cristallographique, et pourront revenir à une même orientation cristallographique si les marques de repérage reviennent dans la même configuration relative par rapport à l'espace les séparant (ici, dans une configuration face-à-face) et que l'on recolle bien les faces parallèlement l'une à l'autre. Dans la suite, les parties des marques de repérage solidaires de la première portion superficielle, donc de la première partie 11 du premier substrat, seront notées 3A tandis que les parties des marques de repérage solidaires de la seconde portion superficielle, donc de la seconde partie 12, seront notées 3B.

Comme indiqué ci-dessus, dans l'exemple représenté, le substrat 1 est homogène, c'est-à-dire que c'est en totalité qu'il est monocristallin, typiquement en silicium. En variante, la couche monocristalline est portée par un support, voire est prise en sandwich entre deux supports. En conséquence, l'une des parties (voire les deux parties du premier substrat obtenues après séparation) ne comporte du matériau monocristallin qu'à proximité immédiate des surfaces mises à nu, donc en des portions superficielles.

Un éventuel traitement de polissage peut être appliqué à la surface de l'une et/ou l'autre des surfaces mises à nu, sous réserve que ce traitement ne modifie pas ou peu (<10-⁵°) l'angle entre, d'une part, les plans cristallographiques les plus parallèles à la surface et, d'autre part, le plan de surface.

La figure 2 représente le résultat d'une première étape de préparation d'un substrat provisoire ; on y voit, sur l'une des parties obtenues par fracture du substrat 1, ici la partie 11, une première famille de zones 13 ; la surface de la partie 11 qui a été mise à nu par la fracture peut éventuellement avoir subi un traitement connu en soi pour faciliter l'accrochage des zones 13. Ces zones sont en un second matériau qui, du point de vue composition et/ou structure cristalline et/ou orientation cristallographique, est différent de celui du premier substrat, donc différent de la partie sous-jacente 11. Dans un mode préféré de l'invention, ces zones sont réalisées par dépôt et gravure d'une couche de Si02.

La figure 3 représente le résultat d'une seconde étape de préparation, ayant abouti à la formation, sur la partie 11, d'une famille de secondes zones 14, adjacentes aux premières zones 13, et qui sont réalisées en un troisième matériau qui, du point de vue composition et/ou structure cristalline et/ou orientation cristallographique, est différent du second matériau constitutif des premières zones 13. Ces secondes zones 14 sont amorphes.

Ces secondes zones 14 forment au moins une partie de la surface libre du substrat provisoire. Dans l'exemple de la figure 3, les zones 14 se prolongent vers le haut au-delà des zones 13, et se prolongent latéralement les unes vers les autres, formant une couche continue recouvrant les zones 13 : on peut donc dire que les zones amorphes forment ainsi la totalité de la surface libre du substrat provisoire (en d'autres termes, c'est la totalité de la surface libre du substrat provisoire qui est formée du matériau amorphe).

A titre d'exemple, dans le cas précité où le premier substrat est en silicium, les premières zones 13 sont en Si02, et le matériau constitutif des zones amorphes est en silicium (ou en variante, en un alliage de silicium, typiquement un alliage de silicium-germanium).

Comme indiqué à la figure 4, après d'éventuelles préparations de surface, on procède ensuite à un collage moléculaire, sur au moins les zones amorphes, de l'autre des parties du premier substrat, à savoir la partie 12 par sa face mise à nu lors de la fracture. Ce collage est effectué en veillant à ce que cette seconde partie 12 ait aussi précisément que possible la même orientation cristallographique que celle de la première portion superficielle, donc de la partie 11, y compris dans le plan des surfaces mises à nu lors de la séparation. On aligne pour cela les marques de repérage réalisées avant fracture, c'est-à-dire que l'on dispose les portions superficielles de manière à ce que les marques 3A et 3B reprennent leur configuration relative d'origine par rapport à la couche mixte (on comprend que cette configuration relative n'a d'importance que parallèlement aux faces mises à nu par la fracture car c'est en fonction de l'orientation angulaire des faces mises à nu, et non pas en fonction de leur écartement, qu'il peut y avoir, ou non, identité des orientations cristallographiques des deux portions superficielles. On comprend également que le positionnement précis des deux portions superficielles pour obtenir une même orientation cristallographique peut être obtenue indépendamment de la présence de marques de repérage creusées ou gravées, voire simplement visuelles, notamment, si l'on conserve la mémoire des manipulations subies par chacune des portions superficielles entre leur séparation et leur solidarisation de part et d'autre de la couche mixte.

On applique ensuite, au moins à la couche mixte formée par les zones 13 et 14 (et éventuellement d'autres zones si plus de deux familles de zones ont été formées entre les deux parties 11 et 12 du premier substrat), un traitement thermique adapté à provoquer, sélectivement par rapport aux premières zones 13, la recristallisation en phase solide d'au moins une partie des zones amorphes 14 ; on comprend que cette recristallisation se fait, non seulement suivant la structure cristalline commune des deux parties 11 et 12, mais aussi suivant leur orientation cristallographique commune ; cela a pour effet que, si la recristallisation se poursuit jusqu'à ce que les fronts de recristallisation partant respectivement de la partie 11 et de la partie 12 se rejoignent, il y a une continuité complète de part et d'autre de ces fronts. Si, par contre, la recristallisation n'a pas effectuée jusqu'à affecter la totalité des zones amorphes, on comprend toutefois que le traitement thermique a abouti à une symétrie au moins approximative entre les parties haute et basse des zones amorphes recristallisées par rapport à une portion médiane non recristallisée, ce qui aboutit notamment à un bon contrôle de la géométrie des zones amorphes recristallisées en leurs parties basse et haute.

On obtient ainsi, si la recristallisation est complète, la configuration de la figure 5, à ceci près que les frontières entre les couches 11 et 12, d'une part, et les zones amorphes recristallisées, se sont en réalité estompées du fait de la recristallisation à partir de ces couches 11 et 12. Par contre, du fait de la continuité entre les parties recristallisées de part et d'autre des fronts de recristallisation, ceux-ci ne sont pas, en pratique visibles.

Il est à noter que la recristallisation est effectuée sélectivement par rapport aux premières zones 13 en ce sens que cette recristallisation est effectuée en sorte de ne pas modifier significativement la structure cristalline (y compris lorsqu'il s'agit d'une forme amorphe) de ces zones 13. Cela peut notamment se faire en choisissant une température et une durée de traitement qui ont un effet bien plus sensible sur les zones 14 que sur les zones 13, ou encore en prévoyant, lors de la préparation des zones 13, des couches propres à minimiser une éventuelle recristallisation selon la structure d'un matériau situé à proximité.

Il suffit alors si on le souhaite de provoquer un enlèvement, de préférence par séparation, de l'une des portions superficielles 11 ou 12 vis-à-vis des zones au moins en partie recristallisées, ici par séparation au niveau de l'interface de collage entre la couche mixte et la couche 12.

La couche mixte a typiquement une épaisseur inférieure au micron, par exemple de l'ordre de 60 nm (non compris la couche surmontant les zones 13).

Dans l'exemple ici considéré, la partie 11 du premier substrat constitue à elle seule le support de la couche mixte, mais on comprend que cette partie 11 peut n'être qu'une couche mince d'épaisseur d'à peine quelques fractions de micron, de sorte qu'il est approprié de la rapporter sur un support, en sorte d'obtenir un ensemble auto-porteur (on estime souvent qu'il faut, pour ce faire, une épaisseur d'au moins 700 microns) ; dans ce cas, le substrat provisoire comporte ce support, le film mince provenant du premier substrat et la couche mixte.

De même, dans cet exemple ici considéré, la partie 12 du premier substrat constitue à elle seule la couche de référence qui est collée, de manière éventuellement temporaire, au substrat provisoire. En variante, cette partie peut être elle aussi rapportée sur un support.

On comprend que cette partie 12 peut ensuite, après séparation vis-à-vis des zones recristallisées, être réutilisée pour un nouveau cycle de production de couches mixtes, en y prélevant une couche mince qui va, lors de ce nouveau cycle, jouer le rôle de la couche 11.

A l'inverse, on peut prévoir de n'utiliser, comme germe de recristallisation « par le dessus », qu'une partie de la couche 12, en découpant, selon la technique « Smart-Cut ^{™} » précitée, une couche que l'on solidarise à un support avant de la coller à la surface libre de la couche mixte.

Cette couche, avec son éventuel support a typiquement une épaisseur de 775 microns (pour 300mm de diamètre), de manière à pouvoir être manipulable.

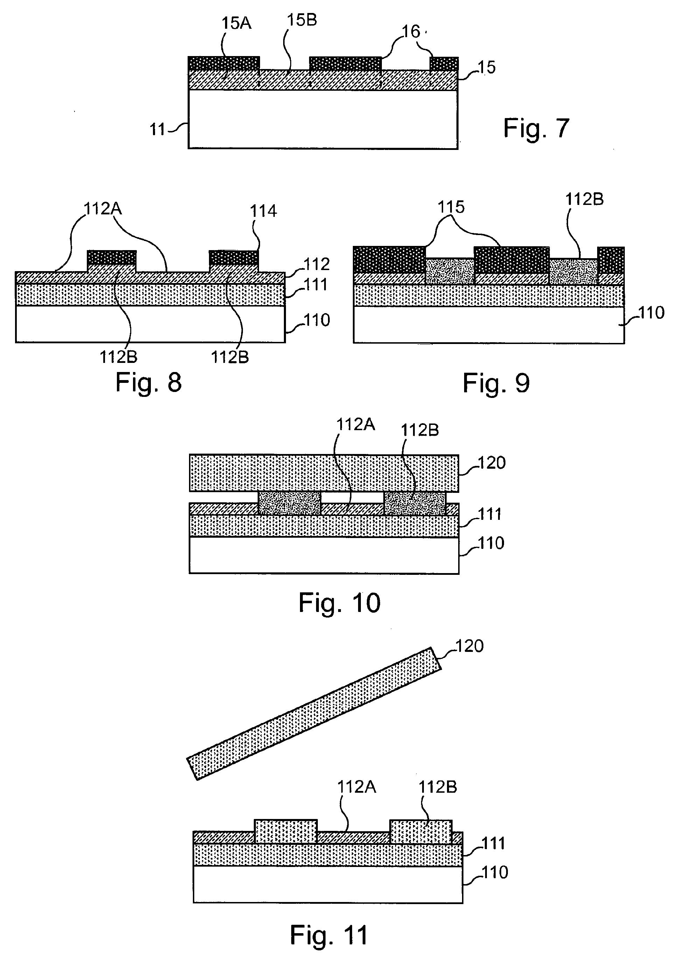

Un exemple de préparation de la couche mixte est schématisé à la figure 7, avec le dépôt d'un masque discontinu 16 sur une couche 15 constituée du matériau des futures premières zones, sur la portion superficielle 11 obtenue par fracture du premier substrat. Ce masque recouvre des zones 15A qui correspondent aux futures premières zones 13. Par attaque au travers du masque 16, on creuse la couche 15, en des zones repérées 15B, jusqu'à la couche 11 ; on peut ensuite déposer, par tout moyen connu approprié, le matériau amorphe en sorte de combler ces cavités et même recouvrir l'ensemble jusqu'à aboutir à la configuration de la figure 3.

Sur cette figure 7 ainsi que sur les suivantes, les éventuelles marques de repérage ont été omises par souci de simplicité.

En variante, lorsque les zones 13 et 14 sont destinées à avoir une même composition, mais avec des structures cristallographiques différentes (ou au moins des orientations cristallographiques différentes), on amorphise, par implantation d'ions, les zones non masquées 15B (dans un tel cas, le matériau amorphe ne s'étend qu'à côté des zones 15A, et non au-dessus).

On comprend que la formation du masque 16 peut être réalisée en plusieurs étapes élémentaires, tout à fait à la portée de l'homme de métier. De manière générale on peut dire que la formation de ce masque est obtenue par des opérations de micro-lithographie connues en soi. Il s'agit avantageusement d'opérations de masquage par photolithographie.

Par élimination du masque, on libère la surface supérieure de la couche mixte à laquelle on peut ensuite coller l'autre partie du premier substrat.

On peut noter que, dans l'exemple des figures 1 à 5, la couche mixte ainsi obtenue à ce stade comporte des familles de zones 13 et 14 qui ont des épaisseurs différentes. En fonction des besoins, une étape optionnelle d'amincissement peut alors être effectuée en sorte d'aboutir à une couche mixte dans laquelle les zones 13 et 14 s'étendent sur la même épaisseur, comme dans le cas précité où on amorphise des zones d'une couche initialement homogène. En variante, une étape de fragilisation, typiquement par bombardement ionique (selon la technologie « Smart Cut ^{™} » par exemple) peut être effectuée au sein même de la couche continue surmontant les premières zones, ce qui permet d'éviter à devoir éliminer par amincissement cette couche continue, lorsqu'une telle élimination est souhaitée.

Le recuit thermique destiné à provoquer la recristallisation peut consister par exemple en une rampe de température de 0,5°C/mn entre 200°C et 1200°C.

Le fait de réaliser la séparation par décollement de l'interface de collage, suppose d'avoir effectué le collage d'une manière conduisant à une tenue mécanique suffisante pour garantir que la couche de référence 12 agit comme un germe de recristallisation lors du traitement thermique, mais suffisamment faible pour permettre, après cette recristallisation, une séparation sans dégrader les substrats, en particulier la couche mixte. Il faut rappeler ici qu'un traitement de recristallisation est un traitement thermique qui est en pratique à une température suffisamment élevée pour tendre à consolider le collage moléculaire, de sorte qu'il faut en tenir compte pour définir le compromis des conditions opératoires du collage moléculaire.

Plusieurs types de traitement (chimique, thermique, plasma, mécanique, etc.) sont à la portée de l'homme de métier pour préparer la surface de la couche de référence et celle de la couche mixte pour les rendre compatibles, des points de vue planéité, rugosité et nature chimique, avec une telle étape de collage moléculaire conduisant à une interface « démontable » compatible avec une transmission de l'information cristallographique pour une bonne recristallisation.

A titre d'exemple, cette rugosification est conduite de manière à ce que la rugosité obtenue soit comprise entre 0.1 nm et 1 nm RMS.

On procède ensuite, de manière optionnelle, à un traitement de surface (chimique et/ou thermique et/ou mécanique, etc.) pour adapter la surface mise à nu par le démontage de l'interface à la suite du traitement que le substrat hybride est destiné à se voir appliquer.

Ce traitement de surface peut, en variante non représentée, être remplacé par un traitement d'amincissement visant à réduire l'épaisseur de la couche mixte, ou du substrat porteur.

Selon encore une autre variante, la couche 12 formant germe est préalablement fragilisée par une implantation d'ions appropriée, de manière à localiser la future séparation en dehors de l'interface de séparation (cette séparation peut aussi être localisée dans la couche continue formant la surface de la couche mixte, lorsque cette couche continue n'a pas vocation à être conservée).

On comprend que le substrat provisoire de la figure 3, après avoir subi la recristallisation de la figure 5 (et la séparation éventuelle de la figure 6), est devenu un substrat mixte présentant une alternance de zones SOI et de zones à conduction verticale.

On comprend aisément que l'on peut, de manière analogue, préparer un substrat mixte ayant, non pas deux familles, mais trois (voire plus) familles de zones.

Il a été mentionné que la recristallisation peut ne pas être complète, en tout cas avant la séparation (lorsqu'elle est prévue). C'est ainsi que le recuit thermique de recristallisation peut être effectué en deux étapes (voire plus), dont une première étape suffisante pour provoquer la recristallisation d'une partie, éventuellement faible, de l'épaisseur des zones amorphes à partir de l'interface. Après séparation, la recristallisation du reste de la couche amorphe peut être obtenue, en une ou plusieurs étapes, en utilisant les parties recristallisées comme germe pour ce reste des zones amorphes. La première étape est par exemple une rampe plus rapide que celle mentionnée ci-dessus.

On comprend que le fait de procéder en deux étapes permet notamment de réduire l'énergie calorifique totale (la seconde étape, après séparation, implique une masse moindre que la première, puisque la couche 12 n'est plus concernée).

Dans l'exemple ci-dessus, les premières zones 13 sont en Si02. Elles peuvent, en variante être en d'autres matériaux amorphes comme un oxyde, un nitrure, de l'alumine, du carbone ou un matériau à haute constante diélectrique « high K ».

Elles pourraient être également en un matériau cristallin différent de celui des zones 14, ou au contraire identique à celui des zones 14 recristallisées mais avec une orientation cristalline différente. Parmi les matériaux cristallins, on peut citer le silicium ou un quelconque autre matériau semi-conducteur, tel que le germanium ou l'un de ses alliages avec le silicium, d'autres alliages de silicium tels que du SiC, ou des alliages entre des éléments des colonnes III et V du tableau périodique des éléments (par exemple GaAs), voire des colonnes II et VI, ou encore le diamant, ou le quartz, ou LiTa03, LiNb03, etc. Dans ce cas, pour limiter la recristallisation suivant le cristal des premières zones 13 à partir de l'interface entre ces premières zones 13 et la couche continue de matériau des zones 14 sus-jacente, on pourra déposer sur les zones 13 une fine couche amorphe (par exemple de Si02) qui pourra éventuellement être éliminée au moment de l'amincissement de la couche mixte après recristallisation.

On comprend ainsi qu'il y a bien des moyens d'obtenir que le traitement thermique provoque la recristallisation des zones 14, sélectivement par rapport aux zones 13, quelle que soit leur structure cristalline (éventuellement amorphe) ; il peut être en outre avantageux de prévoir des tranchées permettant de séparer les zones 13 et les zones 14 ; ces tranchées pourront être remplies ou non par un matériau amorphe.

Les figures 8 à 11 représentent une autre manière de mettre en oeuvre le procédé général des figures 1 à 5 (voire 6) en évitant également une recristallisation sus-jacente à partir des premières zones 13 lorsque celles-ci sont cristallines.

Dans cet exemple, le premier substrat est en silicium monocristallin d'orientation <100>. L'une des parties obtenues par séparation du premier substrat est une couche 111 montée sur un support 110 de composition quelconque, par exemple du silicium polycristallin (éventuellement recouvert d'une couche d'oxyde thermique).

On reporte, par exemple par implantation et fracture, sur cette couche 111 une couche 112 dont une partie est destinée à faire partie de la future couche mixte ; il s'agit, par exemple, comme dans un exemple précité, de silicium monocristallin d'orientation <110>.

A la différence de la figure 7, la première étape de préparation schématisée à la figure 8 comporte la formation d'un premier masque discontinu 114 recouvrant des zones 112B destinées à changer de cristallographie ; en outre, cette première étape comporte un amincissement des zones non masquées 112A. Bien entendu, cet amincissement, qui correspond à la figure 8 à une réduction d'environ la moitié de l'épaisseur initiale de la couche 112, peut être plus modéré.

La figure 9 schématise une seconde étape selon laquelle, en combinaison avec l'élimination du masque 114, on forme un deuxième masque discontinu 115 recouvrant les zones 112A destinées à conserver leur orientation cristalline et on amorphise les zones non masquées ; compte tenu de la première étape de la figure 8, l'amorphisation est effectuée sur une épaisseur (l'épaisseur initiale de la couche 112) qui est supérieure à l'épaisseur des zones masquées 112A. On procède ensuite au retrait du masque 115 ; ces diverses étapes de micro-lithographie sont, en soi, bien connues de l'homme de métier.

A ce stade, le premier substrat comporte des zones amorphisées 112B qui sont en saillie vis-à-vis de zones 112A restées intactes du point de vue cristallographique ; des tranchées sont avantageusement formées entre ces zones 112A et 112B en vue de les séparer, d'un point de vue cristallographique (ces tranchées peuvent être vides, ou comporter un autre matériau amorphe).

On comprend qu'ainsi (voir la figure 10), la mise en contact, à l'aide des éventuelles marques d'alignement (non représentées) du substrat provisoire avec la seconde partie 120 du premier substrat, ne se fait que par l'intermédiaire de la surface libre de ces zones amorphisées ; on évite ainsi d'éventuelles réactions parasites au niveau des surfaces en regard des premières zones 112A et de la couche de référence 120, lors du recuit thermique de recristallisation (figure 10). En outre, l'éventuelle séparation ultérieure de la partie 120 vis-à-vis du substrat provisoire désormais en partie recristallisé en est facilitée (voir la figure 11).

On peut alors effectuer les mêmes opérations optionnelles que dans le premier exemple. En pratique, il est recommandé de procéder à un polissage (ou tout autre traitement lissant, par exemple un recuit sous H2, un recuit sous vide...) visant à rattraper la différence de niveau entre les surfaces libres des zones 112A et 112B ; toutefois, il est possible que cette différence puisse être mise à profit, par exemple pour l'élaboration de tout ou partie de composants.

Ainsi, ce second exemple de mise en oeuvre de l'invention se distingue du premier exemple par le fait que le collage moléculaire est limité aux zones à recristalliser, ce qui tend à protéger les zones devant conserver leur cristallographie.

Comme dans le premier exemple, le recuit de recristallisation peut être réalisé en deux étapes séparées par l'étape de séparation.

Comme précédemment, des étapes optionnelles de préparation de la surface libre du substrat provisoire sont effectuées, de tout type approprié (chimique, thermique, plasma, mécanique, etc.) en sorte de rendre cette surface libre compatible avec un collage moléculaire démontable avec le second substrat 120.

On obtient ainsi un substrat hybride, permettant notamment la production simultanée de transistors à effet de champ de type nFET (sur les zones d'orientation <100>) et pFET (sur les zones d'orientation <110>).

On comprend que l'obtention d'un bon contrôle de la tenue mécanique de l'interface entre les deux substrats est ici facilitée par le fait que, au niveau de cette interface de collage, le premier substrat est entièrement formé d'un unique matériau homogène.

Comme précédemment, la recristallisation peut se faire en plusieurs étapes.

### Bibliographie

Référence 1 : « High Performance CMOS Fabricated on Hybrid Substrate With Different Crystal Orientations » de Yang, Ieong, Shi, Chan, Chan, Chou, Gusev, Jenkins, Boyd, Ninomiya, Pendleton, Surpris, Heenan, Ott, Guarini, D'Emic, Cobb, Mooney, To, Rovedo, Benedict, Mo, Ng, paru dans IEDM 03-2003 pp 453-456,
Référence 2 : "Hybrid-Orientation Technology (HOT): Opportunities and Challenges" de Yang, Chan, Chan, Shi, Fried, Stathis, Chou, Gusev, Ott, Burns, Fischetti, Ieong paru dans IEEE Transaction on Electron Devices, Vol. 53, N° 5, May 2006, pp965-978,
Référence 3 : "Silicon-on-Isolator MOSFETs with Hybrid Crystal Orientations" de Yang, Chan, Kumar, Lo, Sleight, Chang, Rao, Bedell, Ray, Ott, Patel, D'Emic, Rubino, Zhang, Shi, Steen, Sikorski, Newbury, Meyer, To Kozlowski, Graham, Maurer, Medd, Canaperi, Deligianni, Tornello, Gibson, Dalton, Ieong, Shabidi paru dans Symposium on VLSI Technology Digest of Technical Papers, 2006,
Référence 4 : "Direct Silicon Bonded (DSB) Substrate Solid Phase Epitaxy (SPE) Integration Scheme Study for High Performance Bulk CMOS" de Yin, Sung, Ng, Saenger, Chan, Crowder, Zhang, Li, Ott, Pfeiffer, Bendernagel, Ko, Ren, Chen, Wang, Liu, Cheng, Mesfin, Kelly, Ku, Luo, Rovedo, Fogel, Sadana, Khare, Shahidi, paru dans 1-4244-0439-8/06/$20.00 © 2006 IEEE.

## Revendications

1. Procédé d'élaboration d'un substrat hybride selon lequel :
- on prépare un premier substrat (1) dont au moins une couche est monocristalline en un premier matériau,
- on sépare ce premier substrat en deux parties (11, 12 ; 111) de substrat, cette séparation permettant de libérer deux surfaces de deux portions superficielles dont les axes cristallins sont en parfaite coïncidence lors de la séparation,
- on prépare un substrat provisoire en formant sur ladite surface d'une première de ces deux portions superficielles une couche mixte qui est formée de premières zones (13 ; 112A) en au moins un second matériau et de secondes zones (14 ; 112B) adjacentes en un troisième matériau sous forme amorphe, ces secondes zones ayant une différence de composition et/ou de forme cristallographique par rapport aux premières zones et formant au moins une partie de la surface libre de ce substrat provisoire,
- on colle à ce substrat provisoire, par collage moléculaire sur au moins ces zones amorphes (14 ; 112B), ladite surface de la seconde des portions superficielles du premier substrat mise à nu lors de la séparation, de manière à ce qu'elle ait la même orientation cristallographique que la première portion superficielle, et
- on applique au moins à la couche mixte un traitement thermique adapté à provoquer, sélectivement par rapport aux premières zones (13 ; 112A), la recristallisation en phase solide d'au moins une partie des zones amorphes (14 ; 112B) suivant l'orientation cristallographique commune des deux portions superficielles, à partir de chacune de ces portions superficielles.

2. Procédé selon la revendication 1, **caractérisé en ce que**, avant de provoquer la fracture, le long d'une zone préalablement fragilisée, on élabore dans le premier substrat des marques de repérage (3 ; 3A, 3B) adaptées à être disposées de part et d'autre de cette zone fragilisée au moment de cette fracture, selon une configuration relative donnée par rapport à la couche de fracture, et on colle la seconde portion superficielle au substrat provisoire après avoir disposé cette seconde portion en sorte que les marques de repérage soient dans ladite configuration relative donnée par rapport à ladite couche mixte.

3. Procédé selon la revendication 1 ou la revendication 2, **caractérisé en ce que**, après collage de la seconde portion superficielle, on enlève au moins en partie l'une des portions superficielles vis-à-vis de la couche mixte.

4. Procédé selon la revendication 3, **caractérisé en ce que** cet enlèvement est réalisé par séparation entre la portion superficielle et les zones au moins en partie recristallisées de la couche mixte.

5. Procédé selon la revendication 4, **caractérisé en ce que** l'on provoque une rugosification d'au moins l'une des faces destinées à être collées par collage moléculaire et on provoque la séparation à l'interface de collage moléculaire.

6. Procédé selon la revendication 4, **caractérisé en ce que** l'on prépare la seconde portion superficielle en sorte d'en dégrader la tenue mécanique auprès de l'interface de collage moléculaire.

7. Procédé selon la revendication 6, **caractérisé en ce que** l'on applique à la seconde portion superficielle une fragilisation par implantation d'ions à une profondeur donnée, et on provoque la séparation à cette profondeur.

8. Procédé selon l'une quelconque des revendications 4 à 7, **caractérisé en ce que** le traitement thermique de recristallisation n'est adapté à provoquer la recristallisation que d'une partie des zones amorphes et, après séparation, on applique un second traitement thermique adapté à compléter la recristallisation de ces zones amorphes.

9. Procédé selon l'une quelconque des revendications 1 à 8, **caractérisé en ce que** le matériau constitutif des secondes zones (14 ; 112B) a une composition identique à celle des premières zones.

10. Procédé selon l'une quelconque des revendications 1 à 8, **caractérisé en ce que** le matériau constitutif des premières zones (13 ; 112A) et celui des zones amorphes (14 ; 112B)comportent un élément commun.

11. Procédé selon l'une quelconque des revendications 1 à 9, **caractérisé en ce que** la couche mixte est réalisée en un seul matériau ayant, selon les zones, des orientations cristallographiques prédéfinies.

12. Procédé selon la revendication 11, **caractérisé en ce que** les secondes zones (112B) sont obtenues par amorphisation d'une couche monocristalline ayant initialement l'orientation cristallographique des premières zones.

13. Procédé selon l'une quelconque des revendications 1 à 9, **caractérisé en ce que** les secondes zones sont formées par creusement d'une couche monocristalline ayant initialement l'orientation cristallographique des premières zones et par dépôt dans les cavités ainsi creusées du second matériau sous forme amorphe.

14. Procédé selon la revendication 13, **caractérisé en ce que** le dépôt du matériau amorphe est effectué jusqu'à former une couche recouvrant les premières zones (13).

15. Procédé selon l'une quelconque des revendications 1 à 13, **caractérisé en ce que** les premières (13 ; 112A) et secondes (14 ; 112B) zones sont en silicium.

## Patentansprüche

1. Verfahren zur Herstellung eines Hybridsubstrats, gemäß dem:
- ein erstes Substrat (1) hergestellt wird, von dem mindestens eine Schicht monokristallin ist und aus einem ersten Material besteht,
- dieses erste Substrat in zwei Substratteile (11, 12; 111) getrennt wird, wobei diese Trennung ermöglicht, zwei Flächen von zwei Oberflächenabschnitten freizulegen, deren Kristallachsen bei der Trennung genau zusammenfallen,
- ein vorläufiges Substrat hergestellt wird, indem auf der Fläche eines ersten dieser zwei Oberflächenabschnitte eine gemischte Schicht ausgebildet wird, welche von ersten Bereichen (13; 112A) aus mindestens einem zweiten Material und von benachbarten zweiten Bereichen (14; 112B) aus einem dritten Material in amorpher Form gebildet wird, wobei diese zweiten Bereiche eine andere Zusammensetzung und/oder kristallographische Form als die ersten Bereiche aufweisen und wenigstens einen Teil der freien Fläche dieses vorläufigen Substrats bilden,
- auf dieses vorläufige Substrat durch molekulares Kleben auf mindestens einen dieser amorphen Bereiche (14; 112B) die Fläche des zweiten der Oberflächenabschnitte des ersten Substrats, der bei der Trennung freigelegt wurde, geklebt wird, derart, dass er dieselbe kristallographische Orientierung wie der erste Oberflächenabschnitt aufweist, und
- wenigstens auf die gemischte Schicht eine Wärmebehandlung angewendet wird, die geeignet ist, selektiv in Bezug auf die ersten Bereiche (13; 112A) die Rekristallisation in fester Phase wenigstens eines Teils der amorphen Bereiche (14; 112B) gemäß der gemeinsamen kristallographischen Orientierung der zwei Oberflächenabschnitte ausgehend von jedem dieser Oberflächenabschnitte hervorzurufen.

2. Verfahren nach Anspruch 1, **dadurch gekennzeichnet, dass**, bevor der Bruch entlang eines zuvor versprödeten Bereiches hervorgerufen wird, in dem ersten Substrat Kennzeichnungsmarken (3; 3A; 3B) hergestellt werden, die dazu eingerichtet sind, zum Zeitpunkt dieses Bruches beiderseits dieses versprödeten Bereiches angeordnet zu sein, gemäß einer vorgegebenen relativen Konfiguration in Bezug auf die Bruchschicht, und der zweite Oberflächenabschnitt auf das vorläufige Substrat geklebt wird, nachdem dieser zweite Abschnitt derart angeordnet worden ist, dass sich die Kennzeichnungsmarken in der vorgegebenen relativen Konfiguration in Bezug auf die gemischte Schicht befinden.

3. Verfahren nach Anspruch 1 oder Anspruch 2, **dadurch gekennzeichnet, dass** nach dem Kleben des zweiten Oberflächenabschnitts der eine der Oberflächenabschnitte gegenüber der gemischten Schicht wenigstens teilweise entfernt wird.

4. Verfahren nach Anspruch 3, **dadurch gekennzeichnet, dass** dieses Entfernen durch Trennung zwischen dem Oberflächenabschnitt und den wenigstens teilweise rekristallisierten Bereichen der gemischten Schicht realisiert wird.

5. Verfahren nach Anspruch 4, **dadurch gekennzeichnet, dass** eine Aufrauung wenigstens einer der Flächen, die durch molekulares Kleben zusammengeklebt werden sollen, durchgeführt wird und die Trennung an der Grenzfläche des molekularen Klebens hervorgerufen wird.

6. Verfahren nach Anspruch 4, **dadurch gekennzeichnet, dass** der zweite Oberflächenabschnitt derart vorbereitet wird, dass seine mechanische Festigkeit in der Nähe der Grenzfläche des molekularen Klebens verringert wird.

7. Verfahren nach Anspruch 6, **dadurch gekennzeichnet, dass** auf den zweiten Oberflächenabschnitt eine Versprödung durch Ionenimplantation in einer vorgegebenen Tiefe angewendet wird und die Trennung bei dieser Tiefe hervorgerufen wird.

8. Verfahren nach einem der Ansprüche 4 bis 7, **dadurch gekennzeichnet, dass** die Rekristallisationswärmebehandlung geeignet ist, die Rekristallisation nur eines Teils der amorphen Bereiche hervorzurufen, und nach der Trennung eine zweite Wärmebehandlung angewendet wird, die geeignet ist, die Rekristallisation dieser amorphen Bereiche zu vollenden.

9. Verfahren nach einem der Ansprüche 1 bis 8, **dadurch gekennzeichnet, dass** das Material, aus dem die zweiten Bereiche (14; 112B) bestehen, eine Zusammensetzung aufweist, die mit derjenigen der ersten Bereiche identisch ist.

10. Verfahren nach einem der Ansprüche 1 bis 8, **dadurch gekennzeichnet, dass** das Material, aus dem die ersten Bereiche (13; 112A) bestehen, und dasjenige der amorphen Bereiche (14; 112B) ein gemeinsames Element aufweisen.

11. Verfahren nach einem der Ansprüche 1 bis 9, **dadurch gekennzeichnet, dass** die gemischte Schicht aus einem einzigen Material hergestellt wird, das gemäß den Bereichen vordefinierte kristallographische Orientierungen aufweist.

12. Verfahren nach Anspruch 11, **dadurch gekennzeichnet, dass** die zweiten Bereiche (112B) durch Amorphisierung einer monokristallinen Schicht erhalten werden, die ursprünglich die kristallographische Orientierung der ersten Bereiche aufweist.

13. Verfahren nach einem der Ansprüche 1 bis 9, **dadurch gekennzeichnet, dass** die zweiten Bereiche durch Ausbilden von Hohlräumen in einer monokristallinen Schicht, die ursprünglich die kristallographische Orientierung der ersten Bereiche aufweist, und durch Ablagerung des zweiten Materials in amorpher Form in den so gebildeten Hohlräumen gebildet werden.

14. Verfahren nach Anspruch 13, **dadurch gekennzeichnet, dass** die Ablagerung des amorphen Materials durchgeführt wird, bis eine Schicht gebildet wird, welche die ersten Bereiche (13) bedeckt.

15. Verfahren nach einem der Ansprüche 1 bis 13, **dadurch gekennzeichnet, dass** die ersten (13; 112A) und zweiten (14; 112B) Bereiche aus Silizium bestehen.

## Claims

1. A method of producing a hybrid substrate according to which:
- a first substrate (1) is prepared, of which at least one layer is monocrystalline of a first material,
- this first substrate is separated into two parts (11, 12; 111) of substrate, this separation permitting two surfaces of two superficial portions to be freed, the crystalline axes of which are in perfect coincidence upon the separation,
- a temporary substrate is prepared by forming on the said surface of a first of these two superficial portions a mixed layer which is formed by first zones (13; 112A) of at least one second material and by adjacent second zones (14; 112B) of a third material in amorphous form, these second zones having a difference of composition and/or of crystallographic form with respect to the first zones and forming at least a part of the free surface of this temporary substrate,
- the said surface of the second of the superficial portions of the first substrate exposed upon the separation is bonded to this temporary substrate, by molecular bonding on at least these amorphous zones (14; 112B), such that it has the same crystallographic orientation as the first superficial portion, and
- a heat treatment is applied at least to the mixed layer, which treatment is adapted to cause, selectively with respect to the first zones (13; 112A), the solid phase recrystallization of at least a part of the amorphous zones (14; 112B) following the common crystallographic orientation of the two superficial portions, from each of these superficial portions.

2. The method according to Claim 1, **characterized in that**, before causing the fracture, along a previously weakened zone, registration marks (3; 3A, 3B) are prepared in the first substrate, adapted to be disposed on either side of this weakened zone at the moment of this fracture, according to a given relative configuration with respect to the fracture layer, and the second superficial portion is bonded to the temporary substrate after having disposed this second portion such that the registration marks are in the said given relative configuration with respect to the said mixed layer.

3. The method according to Claim 1 or Claim 2, **characterized in that**, after bonding of the second superficial portion, one of the superficial portions is removed at least in part with respect to the mixed layer.

4. The method according to Claim 3, **characterized in that** this removal is realized by separation between the superficial portion and the at least partly recrystallized zones of the mixed layer.

5. The method according to Claim 4, **characterized in that** a roughening is caused of at least one of the faces intended to be bonded by molecular bonding, and the separation is caused at the molecular bonding interface.

6. The method according to Claim 4, **characterized in that** the second superficial portion is prepared so as to reduce its mechanical strength at the molecular bonding interface.

7. The method according to Claim 6, **characterized in that** a weakening is applied to the second superficial portion by implantation of ions at a given depth, and the separation is caused at this depth.

8. The method according to any one of Claims 4 to 7, **characterized in that** the heat treatment of recrystallization is adapted to cause the recrystallization of only a part of the amorphous zones and, after separation, a second heat treatment is applied, which is adapted to complete the recrystallization of these amorphous zones.

9. The method according to any one of Claims 1 to 8, **characterized in that** the constitutive material of the second zones (14; 112B) has an identical composition to that of the first zones.

10. The method according to any one of Claims 1 to 8, **characterized in that** the constitutive material of the first zones (13; 112A) and that of the amorphous zones (14; 112B) comprise a common element.

11. The method according to any one of Claims 1 to 9, **characterized in that** the mixed layer is realized in a single material having, according to the zones, predefined crystallographic orientations.

12. The method according to Claim 11, **characterized in that** the second zones (112B) are obtained by amorphisation of a monocrystalline layer having initially the crystallographic orientation of the first zones.

13. The method according to any one of Claims 1 to 9, **characterized in that** the second zones are formed by excavation of a monocrystalline layer having initially the crystallographic orientation of the first zones and by depositing, in the cavities thus excavated, of the second material in amorphous form.

14. The method according to Claim 13, **characterized in that** the depositing of the amorphous material is carried out until a layer is formed covering the first zones (13).

15. The method according to any one of Claims 1 to 13, **characterized in that** the first (13; 112A) and second (14; 112B) zones are of silicon.
